(19) Europäisches Patentamt / European Patent Office / Office européen des brevets

(11) **EP 3 637 417 B1**

(12) **EUROPEAN PATENT SPECIFICATION**

(45) Date of publication and mention of the grant of the patent:
**07.02.2024 Bulletin 2024/06**

(21) Application number: **19181139.7**

(22) Date of filing: **01.12.2014**

(51) International Patent Classification (IPC):
**G10L 19/02** $^{(2013.01)}$ **G10L 19/002** $^{(2013.01)}$

(52) Cooperative Patent Classification (CPC):
**G10L 19/002; G10L 19/02**

(54) **SIGNAL PROCESSING METHOD AND DEVICE**

SIGNALVERARBEITUNGSVERFAHREN UND -VORRICHTUNG

PROCÉDÉ ET DISPOSITIF DE TRAITEMENT DE SIGNAUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.04.2014 CN 201410177234**

(43) Date of publication of application:
**15.04.2020 Bulletin 2020/16**

(60) Divisional application:
**23213863.6**

(62) Document number(s) of the earlier application(s) in accordance with Art. 76 EPC:
**14891093.8 / 3 079 150**

(73) Proprietor: **Huawei Technologies Co., Ltd.**
**Longgang District**
**Shenzhen, Guangdong 518129 (CN)**

(72) Inventors:
- **WANG, Bin**
  **shenzhen, Guangdong (CN)**
- **MIAO, Lei**
  **shenzhen, Guangdong (CN)**
- **LIU, Zexin**
  **shenzhen, Guangdong (CN)**

(74) Representative: **Huawei European IPR**
**Huawei Technologies Duesseldorf GmbH**
**Riesstraße 25**
**80992 München (DE)**

(56) References cited:
**CN-A- 103 544 957    JP-A- 2005 258 478**
**US-A1- 2012 290 305**

## Description

This application claims priority to Chinese Patent Application No. 201410177234.3, filed with the Chinese Patent Office on April 29, 2014 and entitled "SIGNAL PROCESSING MTHOD AND DEVICE".

## TECHNICAL FIELD

The present invention relates to the signal processing field, and specifically, to a signal processing method and device.

## BACKGROUND

In current communication transmission, increasing attention is paid to quality of a speech signal or an audio signal; therefore, a requirement for signal encoding and decoding is increasingly high. In an existing frequency domain encoding algorithm, bit allocation is generally performed on each sub-band of a signal directly according to a size of a frequency envelope, and then each sub-band is encoded by using a quantity of allocated bits. However, practice shows that, in these existing encoding algorithms, a sub-band of a low frequency band has relatively large impact on signal encoding quality; therefore, the sub-band of the low frequency band generally becomes a bottleneck of signal encoding performance. In addition, the foregoing bit allocation manner cannot well adapt to a bit requirement of each sub-band, especially that of a sub-band of a low frequency band, which leads to relatively poor signal encoding performance. Correspondingly, signal decoding performance is also relatively poor.

JP2005258478A discloses an encoder device includes a down samplers decreases the sampling rate of an input signal from a sampling rate FH to a sampling rate FL. A basic layer encoder encodes a sound signal with the sampling rate FL. A local decoder decodes the encoded code outputted from the basic laser encoder. An up sampler increases the sampling rate of the decoded signal to the sampling rate FH. A subtractor subtracts the decoded signal from the sound signal with the sampling rate FH. An extended layer encoder encodes the signal outputted from the subtractor by using parameters of the decoding result outputted from the local decoder.

US20120290305A1 discloses audio codec to implement distributed mixing and/or sender bit rate regulation in a multipoint conference. The scalable audio codec allows the audio signal from each endpoint to be split into one or more frequency bands and for the transform coefficients within such bands to be prioritized such that usable audio is decoded from a subset of the entire signal. The subset is created by omitting certain frequency bands and/or by omitting certain coefficients within the frequency bands. For each endpoint in a conference, the endpoint determines the importance of its signal to the conference and can select an appropriate bit rate.

CN103544957A discloses a method for allocating bits in an audio signal, which includes: dividing a frequency band of an audio signal into a plurality of subbands, quantizing a subband normalization factor of each subband; grouping the plurality of subbands into a plurality of groups, and acquiring a group parameter of each group, where the group parameter is used to represent a signal characteristic and an energy attribute of an audio signal of the corresponding group; allocating coding bits to at least one group according to the group parameter of each group, where a sum of coding bits allocated to the at least one group is the number of coding bits of the audio signal; and allocating the coding bits allocated to the at least one group to each subband in each group of the at least one group according to the subband normalization factor of each subband in each group of the at least one group.

## SUMMARY

Embodiments of the present invention provide a signal processing method and device, which can improve signal encoding and decoding performance.

The present invention is defined by the independent claims. Further embodiments are defined by the dependent claims.

## BRIEF DESCRIPTION OF DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and persons of ordinary skill in the art may still derive other drawings from these accompanying drawings without creative efforts.

FIG. 1 is a schematic flowchart of a signal processing method according to an embodiment of the present invention;

FIG. 2 is a schematic flowchart of a process of a signal processing method according to an embodiment of the present invention;

FIG. 3 is a schematic block diagram of a signal processing device according to an embodiment of the present invention; and

FIG. 4 is a schematic block diagram of a signal processing device according to another embodiment of the present invention.

## DESCRIPTION OF EMBODIMENTS

The following clearly and completely describes the technical solutions in the embodiments of the present invention with reference to the accompanying drawings in the embodiments of the present invention. Apparently, the described embodiments are some but not all of the embodiments of the present invention.

A signal encoding technology and a signal decoding technology are widely applied to various electronic devices, such as a mobile phone, a wireless apparatus, a personal data assistant (Personal Data Assistant, PDA), a handheld or portable computer, a Global Positioning System (Global Positioning System, GPS) receiver/navigation assistant, a camera, an audio/video player, a video camera, a video recorder, and a monitoring device. Generally, such electronic devices include a speech encoder or an audio encoder, and may further include a speech decoder or an audio decoder. The speech encoder or the audio encoder and the speech decoder or the audio decoder may be directly implemented by a digital circuit or a chip, such as a digital signal processing (Digital Signal Processor, DSP) chip, or may be implemented by a software code-driven processor by executing a procedure in software code.

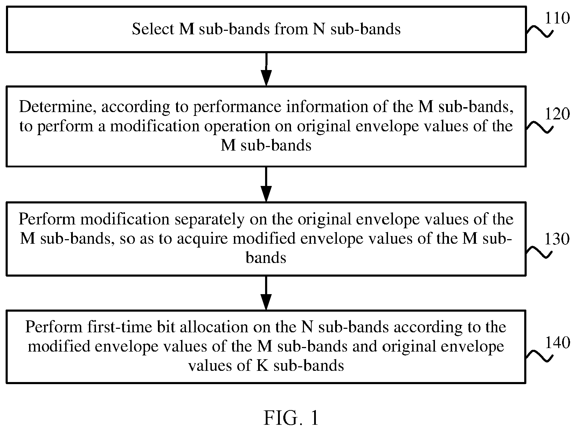

FIG. 1 is a schematic flowchart of a signal processing method according to an embodiment of the present invention. The method in FIG. 1 is executed by an encoder side, such as the foregoing speech encoder or the foregoing audio encoder. The method in FIG. 1 may also be executed by a decoder side, such as the foregoing speech decoder or the foregoing audio decoder.

In an encoding process, the encoder side may first transform a time-domain signal into a frequency-domain signal. For example, time-frequency transformation may be performed by using an algorithm such as fast Fourier transform (Fast Fourier Transform, FFT) or modified discrete cosine transform (Modified Discrete Cosine Transform, MDCT). Then, a global gain may be used to perform normalization on a spectral coefficient of the frequency-domain signal, and division is performed on a normalized spectral coefficient so as to obtain multiple sub-bands.

In a decoding process, the decoder side may decode a bitstream received from the encoder side to obtain a normalized spectral coefficient, and division is performed on the normalized spectral coefficient so as to obtain multiple sub-bands.

110. Select M sub-bands from N sub-bands, where the N sub-bands are obtained by dividing spectral coefficients of a current frame of a signal, frequency bands of the M sub-bands are lower than frequency bands of K sub-bands in the N sub-bands except the M sub-bands, N is a positive integer greater than 1, both M and K are positive integers, and the sum of M and K is N.

In this embodiment of the present invention, the signal may be a speech signal, or may be an audio signal. The foregoing K sub-bands are all sub-bands in the N sub-bands except the M sub-bands.

120. Determine, according to performance information of the M sub-bands, to perform a modification operation on original envelope values of the M sub-bands, where the performance information is used to indicate an energy characteristic and a spectral characteristic that are of the M sub-bands.

130. Perform modification respectively on the original envelope values of the M sub-bands, so as to acquire modified envelope values of the M sub-bands.

140. Perform first bit allocation on the N sub-bands according to the modified envelope values of the M sub-bands and original envelope values of the K sub-bands.

In this embodiment of the present invention, bit allocation is not directly performed according to original envelope values of N sub-bands; instead, M sub-bands with low frequency bands are selected from the N sub-bands, it is determined, according to an energy characteristic and a spectral characteristic that are of the M sub-bands, to perform a modification operation on original envelope values of the M sub-bands, modification is performed respectively on the original envelope values of the M sub-bands according to the original envelope values of the M sub-bands, and first bit allocation is performed on the N sub-bands according to modified envelope values of the M sub-bands and original envelope values of K sub-bands, so that bit allocation better meets a bit requirement of each sub-band, and therefore, signal encoding and decoding performance can be improved.

Specifically, in an existing frequency domain encoding algorithm, bit allocation is performed on each sub-band of a signal directly according to a size of a frequency envelope. As a result, a quantity of allocated bits cannot well meet a bit requirement of some sub-bands with low frequency bands. However, in this embodiment of the present invention, the M sub-bands with low frequency bands are first selected from the N sub-bands, it is determined, according to the energy characteristic and the spectral characteristic that are of the M sub-bands, to perform a modification operation on the original envelope values of the M sub-bands, modification is performed on the original envelope values of the M sub-bands according to the original envelope values of the N sub-bands, and then the first bit allocation is performed on the N sub-bands according to the modified envelope values of the M sub-bands and the original envelope values of the K sub-bands. It may be learned that, in this embodiment of the present invention, bit allocation is not directly performed on the N sub-bands according to the original envelope values of the N sub-bands. Instead, the energy characteristic and the spectral characteristic that are of the M sub-bands are used as considerations to determine that modification needs to be performed on the M sub-bands, so as to obtain the respective modified envelope values of the M sub-bands, and bit allocation is performed according to the modified envelope values of the sub-bands with low frequency bands and original envelope values of other sub-bands, so that bit allocation performed on each sub-band is more proper, especially that performed on the M sub-bands with low frequency bands, and therefore, signal encoding and decoding performance can be improved.

After the spectral coefficients are divided to obtain the N sub-bands, an envelope of each sub-band may be calculated and quantized. Therefore, each sub-band has a quantized envelope value. It should be understood that an original envelope value is relative to a modified envelope value, and the original envelope value may refer to an initial envelope value of a sub-band, that is, a quantized envelope value obtained by calculation after sub-band division. An envelope value obtained after the initial envelope value of the sub-band is modified is referred to as the modified envelope value. Therefore, in this embodiment of the present invention, both the mentioned original envelope value and modified envelope value refer to quantized envelope values.

Optionally, as an embodiment, in step 110, the M sub-bands may be selected from the N sub-bands according to a harmonic characteristic of a sub-band and energy of a sub-band. For example, for the M sub-bands, harmonic strength of each sub-band may be greater than a preset strength threshold, and a ratio of energy of the sub-band to total energy of the N sub-bands is greater than a preset energy threshold. As mentioned above, sub-bands of a low frequency band are generally a bottleneck of signal encoding performance. In these sub-bands, a sub-band that has a relatively strong harmonic characteristic and whose energy accounts for a specific proportion of total energy of all sub-bands is particularly a bottleneck of encoding performance. Therefore, after the M sub-bands are selected from the N sub-bands according to the harmonic characteristic of the sub-band and the energy of the sub-band, and the original envelope values of the M sub-bands are modified, bit allocation performed on the M sub-bands is more proper, and therefore, signal encoding and decoding performance can be efficiently improved.

Optionally, as another embodiment, the N sub-bands may be arranged in ascending order of frequency bands. In this way, in step 110, the first M sub-bands may be selected from the N sub-bands. In this embodiment, the M sub-bands are selected in ascending order of frequency bands, which can simplify an operation and improve signal processing efficiency.

In step 120, a first parameter is determined according to the original envelope values of the N sub-bands, where the first parameter may indicate a concentration degree that is of spectral energy of the signal and that is on the M sub-bands. A second parameter is determined according to the original envelope values of the M sub-bands, where the second parameter indicates a degree of spectral fluctuation of the M sub-bands. In a case in which the first parameter falls within a first range and the second parameter falls within a second range, it is determined to perform a modification operation on the original envelope values of the M sub-bands.

Specifically, the energy characteristic of the M sub-bands may be the concentration degree that is of the spectral energy of the signal and that is on the M sub-bands, and the spectral characteristic of the M sub-bands indicates the degree of spectral fluctuation of the M sub-bands.

The first range is related to energy of a sub-band, and may be preset. When the concentration degree that is of the spectral energy of the signal and that is on the M sub-bands is relatively low, it may indicate that a ratio of the M sub-bands to the N sub-bands is small, and the encoding performance is not greatly affected. Therefore, there is no need to modify the original envelope values of the M sub-bands. When the concentration degree that is of the spectral energy of the signal and that is on the M sub-bands is relatively high, it indicates that the original envelope values of the M sub-bands are also relatively large. Therefore, a quantity of bits allocated to the M sub-bands is enough for encoding, and there is also no need to modify the original envelope values of the M sub-bands. The first range may be predetermined by means of experimental simulation. For example, the first range may be preset to [1/6, 2/3].

The second range is related to a degree of spectral fluctuation of a sub-band, and may be preset. If the degree of spectral fluctuation of the M sub-bands is low, the encoding performance is not greatly affected even if the quantity of bits allocated to the M sub-band is small. In this way, there is no need to modify the original envelope values of the M sub-bands. Therefore, the second range indicates that the degree of spectral fluctuation of the sub-bands is relatively high. The second range may be predetermined by means of experimental simulation. For example, the second range may be preset to $[\frac{1}{0.575*M}, \infty)$ or $[\frac{1}{0.5*M}, \infty)$. Generally, if in a signal, bandwidth that can be used for encoding is 0 to 4 KHz, the second range may be preset to $\left[ \dfrac{1}{0.575 * M} , \infty \right)$ ; if in a signal, bandwidth that can be used for encoding is 0 to 8 KHz, the second range may be preset to $\left[ \dfrac{1}{0.5 * M} , \infty \right)$ .

When the first parameter falls within the first range and the second parameter falls within the second range, it means that the concentration degree that is of the spectral energy of the signal and that is on the M sub-bands is neither extremely high nor extremely low, and that the degree of spectral fluctuation of the M sub-bands is relatively high, and modification may be performed on the original envelope values of the M sub-bands, so that bits allocated to the M sub-bands during the first bit allocation of the M sub-bands better meet a bit requirement of the M sub-bands. For example, for each sub-band in the M sub-bands, a modified envelope value is greater than an original envelope value. Then, compared with performing first bit allocation according to the original envelope values of the M sub-bands, performing first bit allocation according to the modified envelope values of the M sub-bands makes a quantity of bits allocated to the M sub-bands be larger, and therefore, encoding performance of the M sub-bands can be improved.

It may be learned that, in this embodiment, the first parameter and the second parameter that are determined according to the original envelope values of the N sub-bands may reflect a characteristic of each frequency band. Therefore, in a case in which the first parameter falls within the first range and the second parameter falls within the second range, it is determined to perform a modification operation on the original envelope values of the M sub-bands, so that when bit allocation is subsequently performed according to the modified envelope values of the M sub-bands, a quantity of bits allocated to the M sub-bands better meets a bit requirement of the M sub-bands, and therefore, signal encoding and decoding performance can be improved.

In step 120, total energy of the M sub-bands is determined according to the original envelope values of the M sub-bands. Total energy of the K sub-bands is determined according to the original envelope values of the K sub-bands. A ratio of the total energy of the M sub-bands to the total energy of the K sub-bands is determined as the first parameter.

Specifically, the ratio of the total energy of the M sub-bands to the total energy of the K sub-bands is determined as the first parameter.

For example, the first parameter may be obtained by calculation according to the following equations, where the first parameter may be represented by $\alpha$:

$$\alpha = \frac{E_{P_M}}{E_{P_K}}$$

$$E_{P_M} = \sum_{i=0}^{M-1} E_{P\_tmp_i} \qquad E_{P_K} = \sum_{i=M}^{N-M-1} E_{P\_tmp_i}$$

$$E_{P\_tmp_i} = \sqrt{\frac{E_{P_i}}{band\_width_i}} \text{ , and } \quad E_{P_i} = 2^{band\_energy_i} \text{ ,}$$

where

$E_{pM}$ may represent the total energy of the M sub-bands, $E_{P_K}$ may represent the total energy of the K sub-bands, *band_width,* may represent bandwidth of the ith sub-band, and *band_energy,* may represent energy of the ith sub-band. *band_energy,* may represent an original envelope value of the ith sub-band. For example, the original envelope value *band_energy,* of the ith sub-band may be obtained according to a spectral coefficient of the ith sub-band. For example, *band energy,* may be obtained according to the following equations:

$$band\_energy_i = \log_2 E_i \text{ ,}$$

and

$$E_i = \sum_{i=1}^{band\_width_i} t\_audio[j] * t\_audio[j]$$

Optionally, as another embodiment, in step 120, according to the original envelope values of the M sub-bands, total energy of the M sub-bands may be determined, and energy of a first sub-band may be determined, where the energy of the first sub-band is the largest in that of the M sub-bands. A ratio of the energy of the first sub-band to the total energy of the M sub-bands may be determined as the second parameter.

Specifically, the degree of spectral fluctuation of the M sub-bands may be indicated by using a fluctuation degree of the original envelope values of the M sub-bands. For example, the second parameter may be obtained by calculation according to the following equations, where the second parameter may be represented by $\beta$:

$$\beta = \frac{E_{P\_peak}}{E_{P_M}} \text{, and } E_{P\_peak} = \max(E_{p\_tem_0}, E_{p\_tmp_1}, \text{L } E_{p\_tmp_M}),$$

where for calculation manners of $E_{P\_tmp_i}$ and $E_{p_M}$, reference may be made to the foregoing equations.

Optionally, as another embodiment, in step 130, total energy of the M sub-bands and energy of a first sub-band may be determined according to the original envelope values of the M sub-bands, where the energy of the first sub-band is the largest in that of the M sub-bands. A modification factor may be determined according to the total energy of the M sub-bands and the energy of the first sub-band. Then, modification may be performed respectively on the original envelope values of the M sub-bands by using the modification factor, so as to acquire the modified envelope values of the M sub-bands.

For example, the modification factor may be determined according to the following equations, where the modification factor may be represented by $\gamma$:

$$\gamma = \min(1.2, \gamma_0 * \frac{E_{P\_peak} * M}{E_{P_M}}) \text{, and } \gamma_0 = 0.575,$$

where
for calculation manners of $E_{P\_tmp_i}$ and $E_{P_M}$, reference may be made to the foregoing equations.

Modification may be performed on an original envelope value of each sub-band in the M sub-bands according to the modification factor $\gamma$. For example, the original envelope value of each sub-band may be multiplied by the modification factor, so as to obtain a modified envelope value of the sub-band.

Optionally, as another embodiment, in step 130, a modified envelope value of each sub-band in the M sub-bands may be greater than an original envelope value of the sub-band.

Specifically, the modified envelope value of each sub-band in the M sub-bands is obtained by performing modification on the original envelope value of each sub-band in the M sub-bands. The modified envelope value of each sub-band may be greater than the original envelope value of the sub-band. If the modified envelope value of each sub-band in the M sub-bands is greater than the original envelope value of the sub-band, in step 140, bit allocation is performed according to the modified envelope values of the M sub-bands. In this way, a quantity of bits allocated to each sub-band in the M sub-bands increases, so that the bit allocation better meets a bit requirement of each sub-band, and therefore, signal encoding and decoding performance can be improved.

Optionally, as another embodiment, in step 130, a modified envelope value of each sub-band in the M sub-bands may be less than an original envelope value of the sub-band.

Specifically, if the modified envelope value of each sub-band in the M sub-bands may be less than the original envelope value of the sub-band, in step 140, bit allocation is performed according to the modified envelope values of the M sub-bands and original envelope values of the K sub-bands. In this way, a quantity of bits allocated to each sub-band in the M sub-bands is relatively small, and accordingly, quantities of bits respectively allocated to the K sub-bands increase, so that the bit allocation better meets a bit requirement of each sub-band, and therefore, signal encoding and decoding performance can be improved.

Optionally, as another embodiment, in step 130, first bit allocation may be performed on the N sub-bands in descending order of envelope values.

Optionally, as another embodiment, in step 120, a modification factor may be determined according to the second parameter. Then, modification may be performed respectively on the original envelope values of the M sub-bands by using the modification factor, so as to acquire the modified envelope values of the M sub-bands.

Specifically, the modification factor may be determined according to the second parameter. Modification may be performed on an original envelope value of each sub-band in the M sub-bands according to the modification factor. For example, the original envelope value of each sub-band may be multiplied by the modification factor to obtain a modified envelope value of the sub-band, so that a quantity of bits allocated to the M sub-bands better meets a bit requirement of the M sub-bands, and therefore, signal encoding and decoding performance can be improved.

After the first bit allocation is performed, generally, there are redundant bits in a quantity of bits allocated to each sub-band. Redundant bits of each sub-band are not enough for encoding one information unit of the sub-band. Therefore, quantities of redundant bits of all sub-bands may be counted to obtain a total quantity of redundant bits, and then second bit allocation is performed.

Optionally, as another embodiment, after step 140, a quantity of redundant bits of each sub-band in the N sub-bands may be determined according to quantities of bits respectively allocated to the N sub-bands during the first bit allocation, where the quantity of redundant bits of each sub-band in the N sub-bands is less than a quantity of bits required for encoding in the same sub-band. A total quantity of redundant bits may be determined according to the quantity of redundant bits of each sub-band in the N sub-bands. Then, second bit allocation may be performed on the N sub-bands according to the total quantity of redundant bits.

Specifically, total redundant bits may be equally allocated to the N sub-bands. In this way, redundant bits may be reused, so as to avoid a waste of bits and further improve signal encoding and decoding performance.

The foregoing describes a process of first bit allocation and second bit allocation. If the foregoing method in FIG. 1 is executed by an encoder side, after the second bit allocation, the encoder side may quantize a spectral coefficient of each sub-band by using a quantity of bits allocated to each sub-band in a process of the two times bit allocation, write an index of a quantized spectral coefficient and an index of an original envelope value of each sub-band into a bitstream, and then send the bitstream to a decoder side.

If the foregoing method in FIG. 1 is executed by a decoder side, after the second bit allocation, the decoder side may decode a quantized spectral coefficient by using a quantity of bits allocated to each sub-band in a process of the two times bit allocation, so as to obtain a recovered signal.

The following describes embodiments of the present invention in detail with reference to specific examples. It should be understood that, these examples are merely intended to help persons skilled in the art better understand the embodiments of the present invention, but are not intended to limit the scope of the embodiments of the present invention.

In the following examples, an encoder side is used as an example for description.

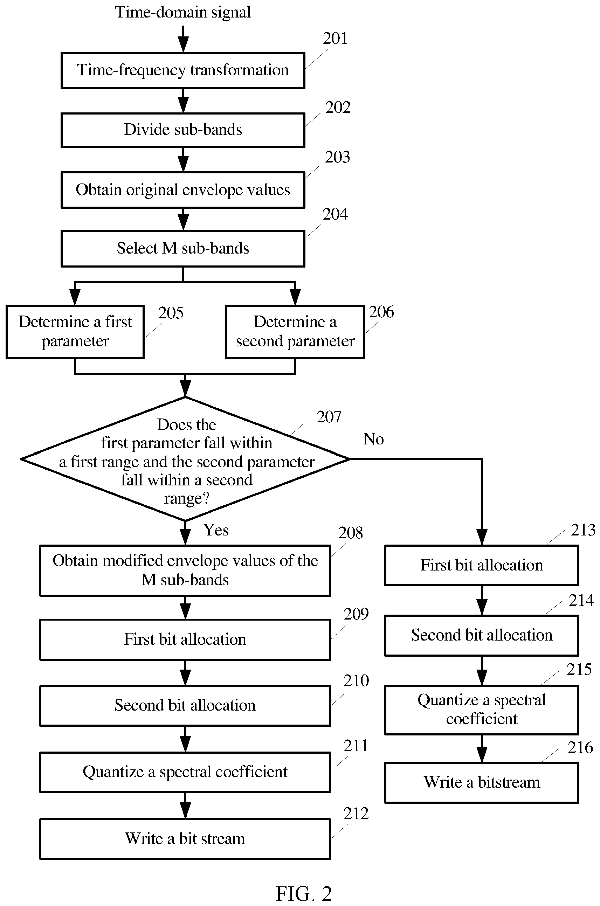

FIG. 2 is a schematic flowchart of a process of a signal processing method according to an embodiment of the present invention.

201. An encoder side performs time-frequency transformation on a time-domain signal.

202. The encoder side divides spectral coefficients of a frequency-domain signal into N sub-bands, where N is a positive integer greater than 1.

Specifically, the encoder side may calculate a global gain; the global gain is used to perform normalization on an original spectral coefficient; then, division is performed on a normalized spectral coefficient so as to obtain all sub-bands.

203. The encoder side obtains an original envelope value of each sub-band by means of a calculation operation and a quantization operation.

204. The encoder side selects M sub-bands from the N sub-bands, where M is a positive integer.

Frequency bands of the M sub-bands are lower than frequency bands of K sub-bands in the N sub-bands except the M sub-bands, where K is a positive integer, and the sum of K and M is N.

205. The encoder side determines a first parameter according to original envelope values of the M sub-bands and original envelope values of K sub-bands.

The first parameter may indicate a concentration degree that is of spectral energy of the signal and that is on the M sub-bands. A ratio of total energy of the M sub-bands to total energy of the K sub-bands is used to indicate the first parameter. For a calculation manner of the first parameter, reference may be made to the calculation manner of the first parameter in the embodiment of FIG. 1, and details are not described again.

206. The encoder side determines a second parameter according to the original envelope values of the M sub-bands.

The second parameter indicates a degree of spectral fluctuation of the M sub-bands. For example, a ratio of energy of a first sub-band to the total energy of the M sub-bands is used to indicate the second parameter, where the energy of the first sub-band is the largest in that of the M sub-bands. For a calculation manner of the second parameter, reference may be made to the calculation manner of the second parameter in the embodiment of FIG. 1, and details are not described again.

207. The encoder side determines whether the first parameter falls within a first range and the second parameter falls within a second range.

The first range and the second range may be preset. For example, the first range may be preset to [1/6, 2/3].

The second range may be preset to $\left[\dfrac{1}{0.575*M}, \infty\right)$ or $\left[\dfrac{1}{0.5*M}, \infty\right)$.

208. If the encoder side determines that the first parameter falls within the first range and the second parameter falls within the second range in step 207, modify the original envelope values of the M sub-bands according to the original envelope values of the M sub-bands, so as to obtain modified envelope values of the M sub-bands.

Specifically, the encoder side may determine a modification factor according to the original envelope values of the M sub-bands. For a calculation manner of the modification factor, reference may be made to the process in the embodiment of FIG. 1, and details are not described again. The encoder side may perform modification on an original envelope value of each sub-band in the M sub-bands by using the modification factor, so as to obtain the modified envelope values of the M sub-bands. For example, a modified envelope value of each sub-band may be greater than the original envelope value of the sub-band.

209. The encoder side performs first bit allocation on the N sub-bands according to the modified envelope values of the M sub-bands and the original envelope values of the K sub-bands.

For example, the encoder side may perform first bit allocation on the N sub-bands in descending order of envelope values. For the M sub-bands, because the modified envelope value of each sub-band is greater than the original envelope value of the sub-band, compared with a quantity of allocated bits before modification, a quantity of bits allocated to each sub-band in the M sub-bands increases, so that bit allocation better meets a bit requirement of each sub-band, thereby improving signal encoding and decoding performance.

210. The encoder side performs second bit allocation on the N sub-bands.

Specifically, the encoder side may determine a quantity of redundant bits of each sub-band according to a quantity of bits allocated to each sub-band in the N sub-bands after the first bit allocation and bandwidth of each sub-band, so as to determine a total quantity of redundant bits of the N sub-bands. Then, total redundant bits are equally allocated to the N sub-bands according to the total quantity of redundant bits.

211. The encoder side quantizes a spectral coefficient of each sub-band according to a quantity of bits allocated to each sub-band in the N sub-bands.

212. The encoder side writes a bitstream according to a quantized spectral coefficient obtained in step 211 and an original envelope value of each sub-band.

Specifically, the encoder side may write indexes of the quantized spectral coefficient, the original envelope value of each sub-band, and the like into the bitstream. For a specific process, reference may be made to the prior art, and details are not described herein again.

213. If the encoder side determines that the first parameter falls outside the first range or the second parameter falls outside the second range in step 207, the encoder side performs first bit allocation on the N sub-bands according to original envelope values of the N sub-bands.

For example, the encoder side may perform first bit allocation on the N sub-bands in descending order of envelope values.

214. The encoder side performs second bit allocation on the N sub-bands.

Specifically, the encoder side may determine a quantity of redundant bits of each sub-band according to a quantity of bits allocated to each sub-band in the N sub-bands after the first bit allocation and bandwidth of each sub-band, so as to determine a total quantity of redundant bits of the N sub-bands. Then, total redundant bits are equally allocated to the N sub-bands according to the total quantity of redundant bits.

215. The encoder side quantizes a spectral coefficient of each sub-band according to a quantity of bits allocated to each sub-band in the N sub-bands.

216. The encoder side writes a bitstream according to a quantized spectral coefficient obtained in step 215 and an original envelope value of each sub-band.

Specifically, the encoder side may write indexes of the quantized spectral coefficient, the original envelope value of each sub-band, and the like into the bitstream. For a specific process, reference may be made to the prior art, and details are not described herein again.

In this embodiment of the present invention, in a case in which a first parameter falls within a first range and a second parameter falls within a second range, modification is performed on original envelope values of M sub-bands with low frequency bands according to the original envelope values of the M sub-bands, and first bit allocation is performed on N sub-bands according to modified envelope values of the M sub-bands and original envelope values of K sub-bands, so that bit allocation better meets a bit requirement of each sub-band, and therefore, signal encoding and decoding performance can be improved.

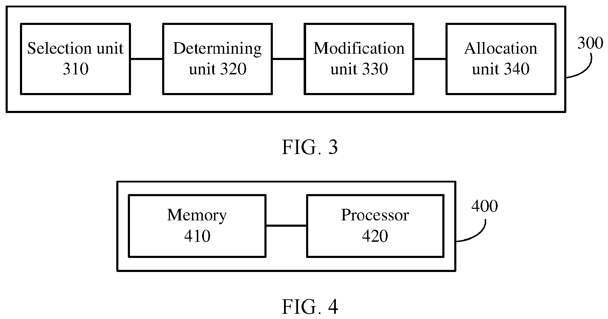

FIG. 3 is a schematic block diagram of a signal processing device according to an embodiment of the present invention. A device 300 in FIG. 3 may be an encoder side device or a decoder side device. The device 300 in FIG. 3 includes a selection unit 310, a determining unit 320, a modification unit 330, and an allocation unit 340.

The selection unit 310 selects M sub-bands from N sub-bands, where the N sub-bands are obtained by dividing spectral coefficients of a current frame of a signal, frequency bands of the M sub-bands are lower than frequency bands of K sub-bands in the N sub-bands except the M sub-bands, N is a positive integer greater than 1, both M and K are positive integers, and the sum of M and K is N. The determining unit 320 determines, according to performance information of the M sub-bands, to perform a modification operation on original envelope values of the M sub-bands, where the performance information is used to indicate an energy characteristic and a spectral characteristic that are of the M sub-bands. The modification unit 330 performs modification respectively on the original envelope values of the M sub-bands, so as to acquire modified envelope values of the M sub-bands. The allocation unit 340 performs first bit allocation on the N sub-bands according to the modified envelope values of the M sub-bands and original envelope values of the K sub-bands.

In this embodiment of the present invention, bit allocation is not directly performed according to original envelope values of N sub-bands; instead, M sub-bands with low frequency bands are selected from the N sub-bands, it is determined, according to an energy characteristic and a spectral characteristic that are of the M sub-bands, to perform a modification operation on original envelope values of the M sub-bands, modification is performed respectively on the original envelope values of the M sub-bands according to the original envelope values of the M sub-bands, and first bit allocation is performed on the N sub-bands according to modified envelope values of the M sub-bands and original envelope values of K sub-bands, so that bit allocation better meets a bit requirement of each sub-band, and therefore, signal encoding and decoding performance can be improved.

Optionally, as an embodiment, the determining unit 320 may determine a first parameter according to original envelope values of the N sub-bands, where the first parameter indicates a concentration degree that is of spectral energy of the signal and that is on the M sub-bands. The determining unit 320 determine a second parameter according to the original envelope values of the M sub-bands, where the second parameter indicates a degree of spectral fluctuation of the M sub-bands. The determining unit 320 determine, in a case in which the first parameter falls within a first range and the second parameter falls within a second range, to perform the modification operation on the original envelope values of the M sub-bands.

The determining unit 320 determines total energy of the M sub-bands according to the original envelope values of the M sub-bands, determines total energy of the K sub-bands according to the original envelope values of the K sub-bands, and determines a ratio of the total energy of the M sub-bands to the total energy of the K sub-bands as the first parameter.

As another embodiment, the determining unit 320 determine total energy of the M sub-bands and energy of a first sub-band according to the original envelope values of the M sub-bands, where the energy of the first sub-band is the largest in that of the M sub-bands. The determining unit 320 determine a ratio of the energy of the first sub-band to the total energy of the M sub-bands as the second parameter.

As another embodiment, the modification unit 330 determine total energy of the M sub-bands and energy of a first sub-band according to the original envelope values of the M sub-bands, where the energy of the first sub-band is the largest in that of the M sub-bands. The modification unit 330 determine a modification factor according to the total energy of the M sub-bands and the energy of the first sub-band, and perform modification respectively on the original envelope values of the M sub-bands by using the modification factor, so as to acquire the modified envelope values of the M sub-bands.

Optionally, as another embodiment, a modified envelope value of each sub-band in the M sub-bands may be greater than an original envelope value of the same sub-band.

Optionally, as another embodiment, the determining unit 320 may further determine a quantity of redundant bits of each sub-band in the N sub-bands according to quantities of bits respectively allocated to the N sub-bands during the first bit allocation, where the quantity of redundant bits of each sub-band in the N sub-bands is less than a quantity of bits required for encoding a single information unit in the same sub-band. The determining unit 320 may further determine a total quantity of redundant bits according to the quantity of redundant bits of each sub-band in the N sub-bands. The allocation unit 340 may further perform second bit allocation on the N sub-bands according to the modified envelope values of the M sub-bands, the original envelope values of the K sub-bands, and the total quantity of redundant bits.

For other functions and operations of the device 300, reference may be made to the processes of the method embodiments in FIG. 1 and FIG. 2. To avoid repetition, details are not described herein again.

FIG. 4 is a schematic block diagram of a signal processing device according to another embodiment of the present invention. A device 400 in FIG. 4 may be an encoder side device or a decoder side device. The device 400 in FIG. 4 includes a memory 410 and a processor 420.

The memory 410 may include a random access memory, a flash memory, a read-only memory, a programmable read-only memory, a non-volatile memory, a register, or the like. The processor 420 may be a central processing unit (Central Processing Unit, CPU).

The memory 410 is configured to store an executable instruction. The processor 420 may execute the executable instruction stored in the memory 410, so as to: select M sub-bands from N sub-bands, where the N sub-bands are obtained by dividing spectral coefficients of a current frame of a signal, frequency bands of the M sub-bands are lower than frequency bands of K sub-bands in the N sub-bands except the M sub-bands, N is a positive integer greater than 1, both M and K are positive integers, and the sum of M and K is N; determine, according to performance information of the M sub-bands, to perform a modification operation on original envelope values of the M sub-bands, where the performance information is used to indicate an energy characteristic and a spectral characteristic that are of the M sub-bands; perform modification respectively on the original envelope values of the M sub-bands, so as to acquire modified envelope values of the M sub-bands; and perform first bit allocation on the N sub-bands according to the modified envelope values of the M sub-bands and original envelope values of the K sub-bands.

In this embodiment of the present invention, bit allocation is not directly performed according to original envelope values of N sub-bands; instead, M sub-bands with low frequency bands are selected from the N sub-bands, it is determined, according to an energy characteristic and a spectral characteristic that are of the M sub-bands, to perform a modification operation on original envelope values of the M sub-bands, modification is performed respectively on the original envelope values of the M sub-bands according to the original envelope values of the M sub-bands, and first bit allocation is performed on the N sub-bands according to modified envelope values of the M sub-bands and original envelope values of K sub-bands, so that bit allocation better meets a bit requirement of each sub-band, and therefore, signal encoding and decoding performance can be improved.

As an embodiment, the processor 420 may determine a first parameter according to original envelope values of the N sub-bands, where the first parameter indicates a concentration degree that is of spectral energy of the signal and that is on the M sub-bands. The processor 420 determine a second parameter according to the original envelope values of the M sub-bands, where the second parameter indicates a degree of spectral fluctuation of the M sub-bands. The processor 420 determine, in a case in which the first parameter falls within a first range and the second parameter falls within a second range, to perform the modification operation on the original envelope values of the M sub-bands.

The processor 420 determines total energy of the M sub-bands according to the original envelope values of the M sub-bands, determines total energy of the K sub-bands according to the original envelope values of the K sub-bands and determines a ratio of the total energy of the M sub-bands to the total energy of the K sub-bands as the first parameter.

As another embodiment, the processor 420 determine total energy of the M sub-bands and energy of a first sub-band according to the original envelope values of the M sub-bands, where the energy of the first sub-band is the largest in that of the M sub-bands. The processor 420 determine a ratio of the energy of the first sub-band to the total energy of the M sub-bands as the second parameter.

As another embodiment, the processor 420 determine total energy of the M sub-bands and energy of a first sub-band according to the original envelope values of the M sub-bands, where the energy of the first sub-band is the largest in that of the M sub-bands. The processor 420 determine a modification factor according to the total energy of the M sub-bands and the energy of the first sub-band, and perform modification respectively on the original envelope values of the M sub-bands by using the modification factor, so as to acquire the modified envelope values of the M sub-bands.

Optionally, as another embodiment, a modified envelope value of each sub-band in the M sub-bands may be greater than an original envelope value of the same sub-band.

Optionally, as another embodiment, the processor 420 may further determine a quantity of redundant bits of each sub-band in the N sub-bands according to quantities of bits respectively allocated to the N sub-bands during the first bit allocation, where the quantity of redundant bits of each sub-band in the N sub-bands is less than a quantity of bits required for encoding a single information unit in the same sub-band. The processor 420 may further determine a total quantity of redundant bits according to the quantity of redundant bits of each sub-band in the N sub-bands. The processor 420 may further perform second bit allocation on the N sub-bands according to the modified envelope values of the M sub-bands, the original envelope values of the K sub-bands, and the total quantity of redundant bits.

For other functions and operations of the device 400, reference may be made to the processes of the method embodiments in FIG. 1 and FIG. 2. To avoid repetition, details are not described herein again.

Persons of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. Persons skilled in the art may use different methods to implement the described functions for each particular application, but it should not be considered that the implementation goes beyond the scope of the present invention.

It may be clearly understood by persons skilled in the art that, for the purpose of convenient and brief description, for a detailed working process of the foregoing system, apparatus, and unit, reference may be made to a corresponding process in the foregoing method embodiments, and details are not described herein again.

In the several embodiments provided in the present application, it should be understood that the disclosed system, apparatus, and method may be implemented in other manners. For example, the described apparatus embodiment is merely exemplary. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual needs to achieve the objectives of the solutions of the embodiments.

In addition, functional units in the embodiments of the present invention may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of the present invention essentially, or the part contributing to the prior art, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in the embodiments of the present invention. The foregoing storage medium includes: any medium that can store program encode, such as a USB flash drive, a removable hard disk, a read-only memory (ROM, Read-Only Memory), a random access memory (RAM, Random Access Memory), a magnetic disk, or an optical disc.

The foregoing descriptions are merely specific implementation manners of the present invention, but are not intended to limit the protection scope of the present invention.

Therefore, the protection scope of the present invention shall be subject to the protection scope of the claims.

**Claims**

1. A signal processing method for processing an audio signal or a speech signal, comprising:

   selecting (110) M sub-bands from N sub-bands, wherein the N sub-bands are obtained by dividing spectral coefficients of a current frame of a signal, frequency bands of the M sub-bands are lower than frequency bands of the other K sub-bands in the N sub-bands, N is a positive integer greater than 1, both M and K are positive integers, and the sum of M and K is N;
   computing and quantizing envelope value of each sub-band of the N sub-bands;
   determining total energy of the M sub-bands according to the quantized envelope values of the M sub-bands;
   determining total energy of the K sub-bands according to the quantized envelope values of the K sub-bands;
   determining a ratio of the total energy of the M sub-bands to the total energy of the K sub-bands as an energy characteristic of the M sub-bands;
   determining (120), in a case in which the energy characteristic falls within a first range and a spectral characteristic of the M sub-bands falls within a second range, to perform a modification operation on quantized envelope values of the M sub-bands, wherein the spectral characteristic of the M sub-bands indicates a degree of spectral fluctuation of the M sub-bands and is obtained based on the quantized envelope values of the M sub-bands;
   performing (130) modification respectively on the quantized envelope values of the M sub-bands, so as to acquire modified envelope values of the M sub-bands; and
   performing (140) first bit allocation on the N sub-bands according to the modified envelope values of the M sub-bands and quantized envelope values of the K sub-bands.

2. The method according to claim 1, wherein the spectral characteristic of the M sub-bands is determined as follows:

   determining energy of a first sub-band according to the quantized envelope values of the M sub-bands, wherein the energy of the first sub-band is the largest in that of the M sub-bands; and
   determining a ratio of the energy of the first sub-band to the total energy of the M sub-bands as the spectral characteristic of the M sub-bands.

3. The method according to claim 1 or 2, wherein the performing modification respectively on the quantized envelope values of the M sub-bands, so as to acquire modified envelope values of the M sub-bands comprises:

determining the energy of the first sub-band according to the quantized envelope values of the M sub-bands, wherein the energy of the first sub-band is the largest in that of the M sub-bands;
determining a modification factor according to the total energy of the M sub-bands and the energy of the first sub-band; and
performing modification respectively on the quantized envelope values of the M sub-bands by using the modification factor, so as to acquire the modified envelope values of the M sub-bands.

4. The method according to claim 3, wherein determining a modification factor according to the total energy of the M sub-bands and the energy of the first sub-band comprises:

determining the modification factor according to the following equation:

$$\gamma = \min(1.2, \gamma_0 * \frac{E_{P\_peak} * M}{E_{P_M}}) \quad ,$$

wherein
$\gamma$ represents the modification factor, $\gamma_0 = 0.575$, $E_{P\_peak}$ represents the energy of the first sub-band, and $E_{pM}$ represents the total energy of the M sub-bands.

5. A signal processing device (300) for processing an audios signal or a speech signal, comprising:

a selection unit (310), configured to select M sub-bands from N sub-bands, wherein the N sub-bands are obtained by dividing spectral coefficients of a current frame of a signal, frequency bands of the M sub-bands are lower than frequency bands of the other K sub-bands in the N sub-bands, N is a positive integer greater than 1, both M and K are positive integers, and the sum of M and K is N;
a determining unit (320), configured to

computing and quantizing envelope value of each sub-band of the N sub-bands;
determine total energy of the M sub-bands according to the quantized envelope values of the M sub-bands;
determine total energy of the K sub-bands according to the quantized envelope values of the K sub-bands;
determine a ratio of the total energy of the M sub-bands to the total energy of the K sub-bands as the energy characteristic of the M sub-bands; and
determine, in a case in which the energy characteristic falls within a first range and a spectral characteristic of the M sub-bands falls within a second range, to perform a modification operation on quantized envelope values of the M sub-bands wherein the spectral characteristic of the M sub-bands indicates a degree of spectral fluctuation of the M sub-bands and is obtained based on the quantized envelope values of the M sub-bands;

a modification unit (330), configured to perform modification respectively on the quantized envelope values of the M sub-bands, so as to acquire modified envelope values of the M sub-bands; and
an allocation unit (340), configured to perform first bit allocation on the N sub-bands according to the modified envelope values of the M sub-bands and quantized envelope values of the K sub-bands.

6. The device according to claim 5, wherein the determining unit is specifically configured to:

determine energy of a first sub-band according to the quantized envelope values of the M sub-bands, wherein the energy of the first sub-band is the largest in that of the M sub-bands; and
determine a ratio of the energy of the first sub-band to the total energy of the M sub-bands as the spectral characteristic of the M sub-bands.

7. The device according to claim 5 or 6, wherein the modification unit is specifically configured to:

determine the energy of the first sub-band according to the quantized envelope values of the M sub-bands, wherein the energy of the first sub-band is the largest in that of the M sub-bands;

determine a modification factor according to the total energy of the M sub-bands and the energy of the first sub-band; and

perform modification respectively on the quantized envelope values of the M sub-bands by using the modification factor, so as to acquire the modified envelope values of the M sub-bands.

8. The device according to claim 7, wherein the modification unit is specifically configured to:

determine the modification factor according to the following equation:

$$\gamma = \min(1.2, \gamma_0 * \frac{E_{P\_peak} * M}{E_{P_M}})$$ ,

wherein

$\gamma$ represents the modification factor, $\gamma_0 = 0.575$, $E_{P\_peak}$ represents the energy of the first sub-band, and $E_{p_M}$ represents the total energy of the M sub-bands.

9. A computer program product, comprising a group of program code, used for performing the method according to any one of claims 1-4.

**Patentansprüche**

1. Signalverarbeitungsverfahren zum Verarbeiten eines Audiosignals oder eines Sprachsignals, umfassend:

Auswählen (110) von M Subbändern aus N Subbändern, wobei die N Subbänder durch Aufteilen von Spektralkoeffizienten eines aktuellen Rahmens eines Signals erhalten werden, Frequenzbänder der M Subbänder niedriger als Frequenzbänder der anderen K Subbänder in den N Subbändern sind, N ein positive ganze Zahl größer als 1 ist, M und K beide positive ganze Zahlen sind und die Summe von M und K gleich N ist;
Berechnen und Quantisieren eines Hüllkurvenwerts für jedes Subband der N Subbänder;
Bestimmen von Gesamtenergie der M Subbänder gemäß den quantisierten Hüllkurvenwerten der M Subbänder;
Bestimmen von Gesamtenergie der K Subbänder gemäß den quantisierten Hüllkurvenwerten der K Subbänder;
Bestimmen eines Verhältnisses der Gesamtenergie der M Subbänder zur Gesamtenergie der K Subbänder als eine Energieeigenschaft der M Subbänder;
Bestimmen (120), falls die Energieeigenschaft in einen ersten Bereich fällt und eine Spektraleigenschaft der M Subbänder in einen zweiten Bereich fällt, eine Modifikationsoperation an quantisierten Hüllkurvenwerten der M Subbänder auszuführen, wobei die Spektraleigenschaft der M Subbänder einen Grad spektraler Fluktuation der M Subbänder angibt und auf der Basis der quantisierten Hüllkurvenwerte der M Subbänder erhalten wird;
Ausführen (130) von Modifikation jeweils an den quantisierten Hüllkurvenwerten der M Subbänder, um so modifizierte Hüllkurvenwerte der M Subbänder zu beschaffen; und
Ausführen (140) von erster Bitvergabe an den N Subbändern gemäß den modifizierten Hüllkurvenwerten der M Subbänder und quantisierten Hüllkurvenwerten der K Subbänder.

2. Verfahren nach Anspruch 1, wobei die Spektraleigenschaft der M Subbänder folgendermaßen bestimmt wird:

Bestimmen von Energie eines ersten Subbands gemäß den quantisierten Hüllkurvenwerten der M Subbänder, wobei die Energie des ersten Subbands die größte in der der M Subbänder ist; und
Bestimmen eines Verhältnisses der Energie des ersten Subbands zur Gesamtenergie der M Subbänder als die Spektraleigenschaft der M Subbänder.

3. Verfahren nach Anspruch 1 oder 2, wobei das Ausführen von Modifikation jeweils an den quantisierten Hüllkurvenwerten der M Subbänder, um so modifizierte Hüllkurvenwerte der M Subbänder zu beschaffen, Folgendes umfasst:

Bestimmen der Energie des ersten Subbands gemäß den quantisierten Hüllkurvenwerten der M Subbänder, wobei die Energie des ersten Subbands die größte in der der M Subbänder ist;
Bestimmen eines Modifikationsfaktors gemäß der Gesamtenergie der M Subbänder und der Energie des ersten Subbands; und

Ausführen von Modifikation jeweils an den quantisierten Hüllkurvenwerten der M Subbänder durch Verwendung des Modifikationsfaktors, um so die modifizierten Hüllkurvenwerte der M Subbänder zu beschaffen.

4. Verfahren nach Anspruch 3, wobei Bestimmen eines Modifikationsfaktors gemäß der Gesamtenergie der M Subbänder und der Energie des ersten Subbands Folgendes umfasst:

Bestimmen des Modifikationsfaktors gemäß der folgenden Gleichung:

$$\gamma = \min(1.2, \gamma_0 * \frac{E_{P\_peak} * M}{E_{P_M}}),$$

wobei

$\gamma$ den Modifikationsfaktor repräsentiert, $\gamma_0 = 0{,}575$ ist, $E_{p\_peak}$ die Energie des ersten Subbands repräsentiert und $E_{p_M}$ die Gesamtenergie der M Subbänder repräsentiert.

5. Signalverarbeitungsvorrichtung (300) zum Verarbeiten eines Audiosignals oder eines Sprachsignals, umfassend

eine Auswahleinheit (310), ausgelegt zum Auswählen von M Subbändern aus N Subbändern, wobei die N Subbänder durch Aufteilen von Spektralkoeffizienten eines aktuellen Rahmens eines Signals erhalten werden, Frequenzbänder der M Subbänder niedriger als Frequenzbänder der anderen K Subbänder in den N Subbändern sind, N ein positive ganze Zahl größer als 1 ist, M und K beide positive ganze Zahlen sind und die Summe von M und K gleich N ist;
eine Bestimmungseinheit (320), ausgelegt zum
Berechnen und Quantisieren eines Hüllkurvenwerts für jedes Subband der N Subbänder;
Bestimmen von Gesamtenergie der M Subbänder gemäß den quantisierten Hüllkurvenwerten der M Subbänder;
Bestimmen von Gesamtenergie der K Subbänder gemäß den quantisierten Hüllkurvenwerten der K Subbänder;
Bestimmen eines Verhältnisses der Gesamtenergie der M Subbänder zur Gesamtenergie der K Subbänder als eine Energieeigenschaft der M Subbänder; und Bestimmen, falls die Energieeigenschaft in einen ersten Bereich fällt und eine Spektraleigenschaft der M Subbänder in einen zweiten Bereich fällt, eine Modifikationsoperation an quantisierten Hüllkurvenwerten der M Subbänder auszuführen, wobei die Spektraleigenschaft der M Subbänder einen Grad spektraler Fluktuation der M Subbänder angibt und auf der Basis der quantisierten Hüllkurvenwerte der M Subbänder erhalten wird;
eine Modifikationseinheit (330), ausgelegt zum
Ausführen von Modifikation jeweils an den quantisierten Hüllkurvenwerten der M Subbänder, um so modifizierte Hüllkurvenwerte der M Subbänder zu beschaffen; und
eine Vergabeeinheit (340), ausgelegt zum Ausführen von erster Bitvergabe an den N Subbändern gemäß den modifizierten Hüllkurvenwerten der M Subbänder und quantisierten Hüllkurvenwerten der K Subbänder.

6. Vorrichtung nach Anspruch 5, wobei die Bestimmungseinheit speziell ausgelegt ist zum

Bestimmen von Energie eines ersten Subbands gemäß den quantisierten Hüllkurvenwerten der M Subbänder, wobei die Energie des ersten Subbands die größte in der der M Subbänder ist; und
Bestimmen eines Verhältnisses der Energie des ersten Subbands zur Gesamtenergie der M Subbänder als die Spektraleigenschaft der M Subbänder.

7. Vorrichtung nach Anspruch 5 oder 6, wobei die Modifikationseinheit speziell ausgelegt ist zum

Bestimmen der Energie des ersten Subbands gemäß den quantisierten Hüllkurvenwerten der M Subbänder, wobei die Energie des ersten Subbands die größte in der der M Subbänder ist;
Bestimmen eines Modifikationsfaktors gemäß der Gesamtenergie der M Subbänder und der Energie des ersten Subbands; und
Ausführen von Modifikation jeweils an den quantisierten Hüllkurvenwerten der M Subbänder durch Verwendung des Modifikationsfaktors, um so die modifizierten Hüllkurvenwerte der M Subbänder zu beschaffen.

8. Vorrichtung nach Anspruch 7, wobei die Modifikationseinheit speziell ausgelegt ist zum

Bestimmen des Modifikationsfaktors gemäß der folgenden Gleichung:

$$\gamma = \min(1.2, \gamma_0 * \frac{E_{P\_peak} * M}{E_{P_M}})$$

,

wobei

$\gamma$ den Modifikationsfaktor repräsentiert, $\gamma_0$ = 0,575 ist, $E_{p\_peak}$ die Energie des ersten Subbands repräsentiert und $E_{p_M}$ die Gesamtenergie der M Subbänder repräsentiert.

9. Computerprogrammprodukt, das eine Gruppe von Programmcode umfasst, das zum Ausführen des Verfahrens nach einem der Ansprüche 1-4 verwendet wird.

**Revendications**

1. Procédé de traitement de signal pour traiter un signal audio ou un signal vocal, comprenant :

la sélection (110) de M sous-bandes parmi N sous-bandes, les N sous-bandes étant obtenues par division de coefficients spectraux d'une trame courante d'un signal, les bandes de fréquences des M sous-bandes étant plus basses que les bandes de fréquences des autres K sous-bandes dans les N sous-bandes, N étant un entier positif supérieur à 1, M et K étant tous deux des entiers positifs, et la somme de M et de K valant N ;
le calcul et la quantification d'une valeur d'enveloppe de chaque sous-bande des N sous-bandes ;
la détermination d'une énergie totale des M sous-bandes selon les valeurs d'enveloppe quantifiées des M sous-bandes ;
la détermination d'une énergie totale des K sous-bandes selon les valeurs d'enveloppe quantifiées des K sous-bandes ;
la détermination d'un rapport de l'énergie totale des M sous-bandes sur l'énergie totale des K sous-bandes comme caractéristique énergétique des M sous-bandes ;
la détermination (120), dans le cas où la caractéristique énergétique s'inscrit dans une première plage et où une caractéristique spectrale des M sous-bandes s'inscrit dans une deuxième plage, de réaliser une opération de modification sur les valeurs d'enveloppe quantifiées des M sous-bandes, la caractéristique spectrale des M sous-bandes indiquant un degré de fluctuation spectrale des M sous-bandes et étant obtenue sur la base des valeurs d'enveloppe quantifiées des M sous-bandes ;
la réalisation (130) d'une modification respectivement sur les valeurs d'enveloppe quantifiées des M sous-bandes, de manière à acquérir des valeurs d'enveloppe modifiées des M sous-bandes ; et
la réalisation (140) d'une première allocation de bits sur les N sous-bandes selon les valeurs d'enveloppe modifiées des M sous-bandes et les valeurs d'enveloppe quantifiées des K sous-bandes.

2. Procédé selon la revendication 1, dans lequel la caractéristique spectrale des M sous-bandes est déterminée comme suit :

la détermination d'une énergie d'une première sous-bande selon les valeurs d'enveloppe quantifiées des M sous-bandes, l'énergie de la première sous-bande étant la plus grande parmi celles des M sous-bandes ; et
la détermination d'un rapport de l'énergie de la première sous-bande sur l'énergie totale des M sous-bandes comme caractéristique spectrale des M sous-bandes.

3. Procédé selon la revendication 1 ou 2, dans lequel la réalisation d'une modification respectivement sur les valeurs d'enveloppe quantifiées des M sous-bandes, de manière à acquérir des valeurs d'enveloppe modifiées des M sous-bandes comprend :

la détermination de l'énergie de la première sous-bande selon les valeurs d'enveloppe quantifiées des M sous-bandes, l'énergie de la première sous-bande étant la plus grande parmi celles des M sous-bandes ;
la détermination d'un facteur de modification selon l'énergie totale des M sous-bandes et l'énergie de la première sous-bande ; et
la réalisation d'une modification respectivement sur les valeurs d'enveloppe quantifiées des M sous-bandes au moyen du facteur de modification, de manière à acquérir les valeurs d'enveloppe modifiées des M sous-bandes.

4. Procédé selon la revendication 3, dans lequel la détermination d'un facteur de modification selon l'énergie totale des M sous-bandes et l'énergie de la première sous-bande comprend :

la détermination du facteur de modification selon l'éauation suivante :

$$\gamma = \min(1{,}2, \gamma_0 * \frac{E_{P\_peak}*M}{E_{P_M}}),$$

$\gamma$ représentant le facteur de modification, $\gamma_0$ = 0,575, $E_{P\_peak}$ représentant l'énergie de la première sous-bande, et $E_{P_M}$ représentant l'énergie totale des M sous-bandes.

5. Dispositif de traitement de signal (300) pour traiter un signal audio ou un signal vocal, comprenant :

une unité de sélection (310), configurée pour sélectionner M sous-bandes parmi N sous-bandes, les N sous-bandes étant obtenues par division de coefficients spectraux d'une trame courante d'un signal, les bandes de fréquences des M sous-bandes étant plus basses que les bandes de fréquences des autres K sous-bandes dans les N sous-bandes, N étant un entier positif supérieur à 1, M et K étant tous deux des entiers positifs, et la somme de M et de K valant N ;
une unité de détermination (320), configurée pour
calculer et quantifier une valeur d'enveloppe de chaque sous-bande des N sous-bandes ;
déterminer une énergie totale des M sous-bandes selon les valeurs d'enveloppe quantifiées des M sous-bandes ;
déterminer une énergie totale des K sous-bandes selon les valeurs d'enveloppe quantifiées des K sous-bandes ;
déterminer un rapport de l'énergie totale des M sous-bandes sur l'énergie totale des K sous-bandes comme caractéristique énergétique des M sous-bandes ; et
déterminer, dans le cas où la caractéristique énergétique s'inscrit dans une première plage et où une caractéristique spectrale des M sous-bandes s'inscrit dans une deuxième plage, de réaliser une opération de modification sur les valeurs d'enveloppe quantifiées des M sous-bandes, la caractéristique spectrale des M sous-bandes indiquant un degré de fluctuation spectrale des M sous-bandes et étant obtenue sur la base des valeurs d'enveloppe quantifiées des M sous-bandes ;
une unité de modification (330), configurée pour réaliser une modification respectivement sur les valeurs d'enveloppe quantifiées des M sous-bandes, de manière à acquérir des valeurs d'enveloppe modifiées des M sous-bandes ; et
une unité d'allocation (340), configurée pour réaliser une première allocation de bits sur les N sous-bandes selon les valeurs d'enveloppe modifiées des M sous-bandes et les valeurs d'enveloppe quantifiées des K sous-bandes.

6. Dispositif selon la revendication 5, dans lequel l'unité de détermination est plus particulièrement configurée pour :

déterminer une énergie d'une première sous-bande selon les valeurs d'enveloppe quantifiées des M sous-bandes, l'énergie de la première sous-bande étant la plus grande parmi celles des M sous-bandes ; et
déterminer un rapport de l'énergie de la première sous-bande sur l'énergie totale des M sous-bandes comme caractéristique spectrale des M sous-bandes.

7. Dispositif selon la revendication 5 ou 6, dans lequel l'unité de modification est plus particulièrement configurée pour :

déterminer l'énergie de la première sous-bande selon les valeurs d'enveloppe quantifiées des M sous-bandes, l'énergie de la première sous-bande étant la plus grande parmi celles des M sous-bandes ;
déterminer un facteur de modification selon l'énergie totale des M sous-bandes et l'énergie de la première sous-bande ; et
réaliser une modification respectivement sur les valeurs d'enveloppe quantifiées des M sous-bandes au moyen du facteur de modification, de manière à acquérir les valeurs d'enveloppe modifiées des M sous-bandes.

8. Dispositif selon la revendication 7, dans lequel l'unité de modification est plus particulièrement configurée pour :

déterminer le facteur de modification selon l'équation suivante :

$$\gamma = \min(1,2, \gamma_0 * \frac{E_{P\_peak}*M}{E_{P_M}}),$$

$\gamma$ représentant le facteur de modification, $\gamma_0$ = 0,575, $E_{P\_peak}$ représentant l'énergie de la première sous-bande, et $E_{P_M}$ représentant l'énergie totale des M sous-bandes.

9. Produit-programme d'ordinateur, comprenant un groupe de codes de programme, utilisé pour réaliser le procédé selon l'une quelconque des revendications 1 à 4.

```
┌────────────────────────────────────────────────────────────┐
│            Select M sub-bands from N sub-bands              │ ~ 110
└────────────────────────────────────────────────────────────┘
                              │
                              ▼
┌────────────────────────────────────────────────────────────┐
│ Determine, according to performance information of the M sub-bands, │ ~ 120
│ to perform a modification operation on original envelope values of the │
│                        M sub-bands                         │
└────────────────────────────────────────────────────────────┘
                              │
                              ▼
┌────────────────────────────────────────────────────────────┐
│ Perform modification separately on the original envelope values of the │ ~ 130
│ M sub-bands, so as to acquire modified envelope values of the M sub- │
│                          bands                            │
└────────────────────────────────────────────────────────────┘
                              │
                              ▼
┌────────────────────────────────────────────────────────────┐
│ Perform first-time bit allocation on the N sub-bands according to the │ ~ 140
│ modified envelope values of the M sub-bands and original envelope │
│                    values of K sub-bands                   │
└────────────────────────────────────────────────────────────┘
```

FIG. 1

Time-domain signal

Time-frequency transformation    201

Divide sub-bands    202

Obtain original envelope values    203

Select M sub-bands    204

Determine a first parameter    205

Determine a second parameter    206

Does the first parameter fall within a first range and the second parameter fall within a second range?    207

No

Yes

Obtain modified envelope values of the M sub-bands    208

First bit allocation    209

Second bit allocation    210

Quantize a spectral coefficient    211

Write a bit stream    212

First bit allocation    213

Second bit allocation    214

Quantize a spectral coefficient    215

Write a bitstream    216

FIG. 2

| Selection unit 310 | Determining unit 320 | Modification unit 330 | Allocation unit 340 | 300 |
| --- | --- | --- | --- | --- |

FIG. 3

| Memory 410 | Processor 420 | 400 |
| --- | --- | --- |

FIG. 4

**EP 3 637 417 B1**

## REFERENCES CITED IN THE DESCRIPTION

**Patent documents cited in the description**

- CN 201410177234
- JP 2005258478 A
- US 20120290305 A1
- CN 103544957 A